# EUROPÄISCHE PATENTSCHRIFT

(11) **EP 3 134 917 B1**
(45) Veröffentlichungstag und Bekanntmachung des Hinweises auf die Patenterteilung: **21.07.2021**
(21) Anmeldenummer: 14730197.2
(22) Anmeldetag: 23.04.2014
(51) Int. Cl.: H01L 21/677

(54) **VERBESSERTES REINRAUMSHUTTLE**
IMPROVED CLEANROOM SHUTTLE
SYSTÈME DE NAVETTE AMÉLIORÉ POUR SALLE BLANCHE

(43) Veröffentlichungstag der Anmeldung: 01.03.2017
(73) Patentinhaber: Schiller Automatisierungstechnik GmbH, 94486 Osterhofen (DE)
(72) Erfinder: BRANDL, Gottfried, 94491 Hengersberg (DE); NISCHLER, Anton, 94542 Haarbach (DE); KAGLEDER, Karl, 84381 Johanniskirchen (DE); HAIDER, Markus, 94086 Bad Griesbach (DE); BROCHER, Markus, 94491 Hengersberg (DE); STEINBEISSER, Hermann, 94405 Landau an der Isar (DE)
(74) Vertreter: Wittmann, Günther
(86) Internationale Anmeldenummer: PCT/IB2014/060947
(87) Internationale Veröffentlichungsnummer: WO 2015/162453

(56) Entgegenhaltungen:
- EP-A1- 0 889 515
- WO-A1-2009/113725
- JP-A- H1 039 926
- US-A1- 2002 165 648
- US-A1- 2004 253 087

## Beschreibung

Die vorliegende Erfindung betrifft ein verbessertes Reinraumshuttle. Insbesondere betrifft die vorliegende Erfindung ein Reinraumshuttle mit einer besonders niedrigen Partikelemission.
In Reinräumen werden Güter hergestellt, die besonders hohe Anforderungen an eine partikelfreie Umgebung stellen. In Reinräumen werden beispielsweise Halbleiterschaltungen, keramische Schaltungen, Medizintechnikprodukte und dergleichen hergestellt, um nur einige Beispiele zu nennen.
Reinräume weisen gegenüber ihrer Umgebung einen Überdruck auf, so dass Partikel durch den natürlichen Luftstrom aus dem Reinraum abtransportiert werden und keine Partikel in den Reinraum hineintransportiert werden. Es versteht sich, dass Geräte, die in einem Reinraum eingesetzt werden, eine besonders niedrige Partikelemission aufweisen müssen. Das bedingt unter anderem, dass derartige Geräte in einem Reinraum besonders reibungsarm und abriebarm ausgelegt sein müssen.
Die in einem Reinraum hergestellten Produkte werden unter anderem mittels eines so genannten Reinraumshuttle transportiert. Es ist beispielsweise bekannt, dass Wafer für die Herstellung elektronischer Schaltungen in einem Behälter angeordnet sind, der von dem Reinraumshuttle, beispielsweise zur nächsten Arbeitsstation, transportiert wird.
Im Stand der Technik werden Reinraumshuttle verwendet, die Schienensysteme und schienengebundene Fahrzeuge umfassen und den Nachteil aufweisen, dass in den Kurven, aber auch bei einer Geradeausfahrt, Reibung entstehen kann, die zu einem Abrieb und folglich zu einer Partikelemission führen kann. Ferner weisen schienengebundene und laufkatzengebundene Reinraumshuttle vergleichsweise große Kurvenradien auf, so dass sie nicht flexibel in einer Fertigungsumgebung eingesetzt werden können und zusätzlichen Raum benötigen. Ein weiterer Nachteil der Systeme des Standes der Technik ist, dass die Fahrstrecke aktive Elemente erfordert, beispielsweise Weichen, die Partikel emittieren. Ferner beeinträchtigen die aktiven Elemente die Erweiterbarkeit der Shuttlesysteme.

Die EP 0 889 515 A1 offenbart einen Transportroboter, der von einer magnetischen Schiene geführt wird, auf dem eine staubfreie Lage 36 angeordnet ist.

Die WO 2009/113725 A1 offenbart ein Fahrzeug, mit schwenkbaren Achsen bzw. Radsätzen, wobei an der Achse beiderseits des Drehpunktes je ein Rad angeordnet ist. Die Achsen sind entlang Schienen verschiebbar.

Die Erfindung stellt sich zur Aufgabe, ein verbessertes Reinraumshuttle zu schaffen. Das verbesserte Reinraumshuttle kann so ausgelegt sein, dass es weniger Partikel als der Stand der Technik emittiert. Ferner kann das verbesserte Reinraumshuttle so ausgelegt sein, dass es flexibler einsetzbar ist.

Die Aufgabe der Erfindung wird durch ein Reinraumshuttlesystem gelöst, das dazu ausgebildet ist, in einem Reinraum Gegenstände zu transportieren und dazu ausgebildet ist, die Anforderungen an die maximale zulässige Partikelemission des Reinraums zu erfüllen. Das Reinraumshuttlesystem umfasst eine Fahrbahn, auf der sich ein Rad in zumindest zwei Dimensionen bewegen kann und die höher als die Raumbodenoberkante des Reinraums angeordnet ist. Das Reinraumshuttle umfasst zumindest drei lenkbare Räder, die sich auf der Fahrbahn bewegen und diese berühren. Die maximal zulässige Partikelemission kann in ISO 14644-1/GMP-Leitfaden Annex 1 je nach Reinraumklasse festgelegt sein.

Das erfindungsgemäße Reinraumshuttle berührt die Fahrbahn lediglich an den Radaufstandspunkten. Die Fahrbahn kann hinsichtlich Kurven, Abzweigungen und Kreuzungen beliebig ausgebildet sein. Die Fahrbahn umfasst lediglich passive Elemente. Aktive Fahrbahnelemente sind nicht erforderlich. Ein Aufzug ist kein Fahrbahnelement im Sinne dieser Erfindung.

Das Rad kann sich auf der Fahrbahn in zumindest zwei Dimensionen bewegen, was bedeutet, dass sich das Rad in einer ersten translatorischen Richtung und in einer zweiten translatorischen Richtung, die unter einem Winkel zur ersten translatorischen Richtung angeordnet ist, bewegen kann. Die erste translatorische Richtung und die zweite translatorische Richtung können senkrecht zueinander sein. Jedes der Räder kann unabhängig voneinander gelenkt werden.

Der Punkt, auf dem das Rad die Fahrbahn berührt, kann sich exzentrisch zu der Achse befinden, um die das Rad während einer Lenkbewegung geschwenkt wird. Dadurch wird sichergestellt, dass das Rad während einer Lenkbewegung abgerollt wird, wodurch eine Reibung und somit ein Abrieb mit einer Partikelemission vermieden werden. Während der Lenkbewegung eines Rades kann dieses Rad entsprechend der Lenkbewegung angetrieben werden, um die Lenkbewegung zu unterstützen oder sich in einem Leerlauf befinden, in welchem sich das Rad frei bewegen kann. Dadurch kann sichergestellt werden, dass besonders wenige Partikel emittiert werden.

Jedes der Räder kann in eine Mehrzahl translatorischer Richtungen gelenkt werden. Jedes der Räder kann in einem Winkelbereich von etwa 0° bis etwa +/- 90°, vorzugsweise von etwa 0° bis etwa +/- 135° gelenkt werden. Dadurch ist es möglich, dass das Reinraumshuttle seine Fahrtrichtung ändern kann, ohne dass Kurvenradien eingehalten werden müssen. Beispielsweise kann das Reinraumshuttle einen Punkt unter einer ersten translatorischen Richtung ansteuern und an diesem Punkt anhalten. Das Reinraumshuttle kann anschließend den Einschlagwinkel der lenkbaren Räder ändern, so dass das Reinraumshuttle sich von dem Punkt unter einem zweiten Winkel wegbewegen kann. Die beiden Richtungen können vorzugsweise rechtwinklig zueinander stehen. Dadurch ist es möglich, das Reinraumshuttle in beliebigen Produktionsumgebungen einzusetzen. Da das erfindungsgemäße Reinraumshuttlesystem Stichfahrten ermöglicht, kann es in bestehenden Anlagen nachgerüstet werden, ohne dass aufwendige Umbauten erforderlich sind, erhebliche Kosten entstehen und lange Stillstandzeiten verursacht werden.

Da jedes Rad des Reinraumshuttle, das die Fahrbahn berührt, individuell und unabhängig voneinander lenkbar ist, wird ein Abrieb vermieden. Folglich emittiert das Reinraumshuttle wenig Partikel.

Der Vortrieb der Räder, die die Fahrbahn berühren, kann so gesteuert bzw. geregelt werden, dass sich bei einer Kurvenfahrt eine Differentialwirkung ergibt, d.h. die Räder bewegen sich derart auf der Fahrbahn, dass auch bei einer Kurvenfahrt der Schlupf minimiert wird und/oder kein Schieben erfolgt, wodurch die Partikelemission reduziert wird.
Bei einer bevorzugten Ausgestaltung kann das Reinraumshuttle zumindest vier lenkbare Räder aufweisen, die sich auf der Fahrbahn bewegen und diese berühren. Jedes der Räder kann eine Lenkbewegung um zumindest +/- 90°, vorzugsweise +/-135°, durchführen.

Jedes der Räder, das die Fahrbahn berührt, weist einen Lenkantrieb auf, der das Rad für eine Lenkbewegung schwenkt. Jedes der Räder, das die Fahrbahn berührt, kann durch einen Vortriebsantrieb angetrieben werden, der das Reinraumshuttle bewegt.
Die Lenkachse, um die das Rad des Reinraumshuttle während des Lenkens geschwenkt wird, kann hohl ausgebildet sein. Durch die hohle Achse können Kabel und dergleichen geführt werden, so dass vermieden wird, dass Partikel, die durch Bewegen der Kabel während des Lenkens entstehen, aus dem Reinraumshuttle austreten können.
Das Reinraumshuttle kann eine Steuerungseinrichtung aufweisen, die dazu ausgebildet ist, jedes der zumindest drei Räder um einen vorbestimmten Betrag zu schwenken, so dass das Reinraumshuttle nach einer Fahrt in eine erste Richtung die Fahrt in eine zweite Richtung fortsetzt. Die erste Richtung und die zweite Richtung können unter einem Winkel zueinander, vorzugsweise rechtwinklig, zueinander angeordnet sein. Wie zuvor erwähnt wurde, kann dadurch sichergestellt werden, dass das Reinraumshuttle mehr oder weniger "auf einer Stelle" seine Fahrtrichtung ändern kann und keine mehr oder weniger großzügigen Kurvenradien vorgesehen sein müssen.
Zumindest zwei Räder des Reinraumshuttle können an einem Träger angeordnet sein, der gegenüber dem Chassis des Reinraumshuttle schwenkbar angeordnet ist. Der Träger kann am Chassis schwenkbar angeordnet sein. Dadurch kann sichergestellt sein, dass immer alle Räder die Fahrbahn berühren, obwohl die Fahrbahn Unebenheiten aufweist. Dies ist insbesondere dann relevant, wenn das Reinraumshuttle vier oder mehr Räder aufweist, da bereits durch drei Punkte eine Ebene definiert ist.

Das Reinraumshuttle kann eine Hebeeinrichtung aufweisen, die dazu ausgebildet ist, einen Behälter zu heben und/oder zu senken. Die Hebeeinrichtung kann zumindest ein Seil, vorzugsweise zumindest zwei Seile, aufweisen, die einen Greifer tragen, der den Behälter greift. Über zumindest ein Seil können ein Kommunikationssignal und/oder eine Energieversorgung für den Greifer übertragen werden. Über die Seile, die die Greifer tragen kann ein Kommunikationsbus, beispielsweise I²C oder 2wire, übertragen werden.

Da die für die mechanische Hubbewegung verwendeten Seile auch zur Übertragung von Kommunikationssignalen und einer Energieversorgung dienen, kann die Anzahl benötigter, insbesondere der bewegten, Teile reduziert werden, wodurch die Partikelemission weiter reduziert wird.

Die Hebeeinrichtung des Reinraumshuttle und/oder eine Hebeeinrichtung des Reinraumshuttlesystems können eine helixförmige, Steigung bzw. Vertiefung, beispielsweise auf einer Trommel, aufweisen, von der ein Seil beim Bewegen des Behälters aufgenommen wird. Das Seil zum Tragen des Behälters bzw. des Greifers wird folglich in der helixfömigen Vertiefung aufgerollt. Dadurch wird die Seilreibung reduziert, wodurch die Partikelemission weiter reduziert wird. Die helixförmige Vertiefung in Verbindung mit einer geeigneten Materialpaarung reduziert weiter die Partikelemission. Bevorzugt werden weiche Materialien, insbesondere für die Seilummantelung, die zugleich elektrisch isolierend wirkt.

An der Fahrbahn kann eine Mehrzahl von Markierungen angeordnet sein, und das Reinraumshuttle kann zumindest einen Positionssensor aufweisen, der dazu ausgebildet ist, die Position des Reinraumshuttle in Fahrbahnlängsrichtung und/oder die Position des Reinraumshuttle in Fahrbahnquerrichtung berührungslos zu ermitteln. Der zumindest eine Positionssensor kann die Referenzposition berührungslos ermitteln. Die Markierungen können eine Mehrzahl von Strichen sein, die beispielsweise wie ein Barcode aufgebaut sind. Beispielsweise kann der Sensor des Reinraumshuttle die Position absolut aufgrund der Anzahl von Strichen ermitteln. Ferner können zusätzliche Markierungen an der Fahrbahn angeordnet sein, die eine Referenzmarkierung bilden, damit die ermittelte Position des Reinraumshuttle verifiziert werden kann.

Die Markierungen können Striche aufweisen, deren längere Seite sich einen Teil der Breite der Fahrbahn in Fahrbahnquerrichtung erstreckt und deren kürzere Seite sich in Fahrbahnlängsrichtung erstreckt. Der zumindest eine Positionssensor kann dazu ausgebildet sein, die Position des Reinraumshuttle entlang der Fahrbahnlängsrichtung der Fahrbahn mittels der längeren Seite der Markierung und die Position des Reinraumshuttle in Fahrbahnquerrichtung mittels der kürzeren Seite der Markierung zu bestimmen.

An der Fahrbahn kann eine Leitplanke angeordnet sein, die verhindert, dass das Reinraumshuttle von der Fahrbahn abkommt.

Das Reinraumshuttle kann eine erste Messeinrichtung aufweisen, die Markierungen auf der Fahrbahn auswertet. Die Markierungen auf der Fahrbahn können beispielsweise die zuvor genannten Striche sein. Die erste Messeinrichtung kann der zuvor erwähnte Positionssensor sein. Das Reinraumshuttle kann ferner eine zweite Messeinrichtung aufweisen, die den Abstand des Reinraumshuttles zu einem Punkt ermittelt. Der Punkt kann eine Fahrbahnbegrenzung, beispielsweise die zuvor erwähnte Leitplanke, sein. Die zweite Messrichtung kann einen Laser und/oder Ultraschallsensor aufweisen. Die Steuerrichtungseinrichtung des Reinraumshuttles kann dazu ausgebildet sein, dass bei einer ersten Fahrtrichtung die Position des Reinraumshuttles entlang der Fahrbahn durch die erste Messeinrichtung ermittelt wird und die Position senkrecht zur Fahrtrichtung durch die zweite Messeinrichtung ermittelt wird. Ferner kann die Steuerungseinrichtung dazu ausgebildet sein, dass bei einer zweiten Fahrtrichtung die Position des Reinraumshuttles entlang der Fahrbahn durch die zweite Messeinrichtung ermittelt wird und die Position senkrecht zur Fahrtrichtung durch die erste Messeinrichtung ermittelt wird. Die zweite Fahrtrichtung kann senkrecht zur ersten Fahrtrichtung sein. Die erste Fahrtrichtung kann die übliche Fahrtrichtung des Reinraumshuttles sein, und die zweite Fahrtrichtung kann eine sogenannte Stichfahrt sein, die sich senkrecht zur ersten Fahrtrichtung befindet. Durch diese Ausgestaltung wird sichergestellt, dass mit möglichst wenigen Messeinrichtungen die Position des Reinraumshuttles unabhängig von der Fahrtrichtung bestimmt werden kann.

Alternativ hierzu kann das Reinraumshuttlesystem eine erste Messeinrichtung aufweisen, die Markierungen auf der Fahrbahn auswertet, und eine zweite Messeinrichtung aufweisen, die den Abstand des Reinraumshuttles zu einem Punkt im Raum ermittelt, wenn sich das Reinraumshuttle in einer ersten Richtung bewegt. Die erste Richtung befindet sich in der Richtung der Fahrbahn. Die Steuerungseinrichtung kann dazu ausgebildet sein, dass sie, wenn sich das Reinraumshuttle in die erste Fahrtrichtung bewegt, die Position des Reinraumshuttles entlang der Fahrbahn durch die erste Messeinrichtung ermittelt und die Position senkrecht zur Fahrtrichtung durch die zweite Messeinrichtung ermittelt. Die zweite Messeinrichtung kann die Position des Reinraumshuttles gegenüber einer Fahrbahnbegrenzung, beispielsweise der Leitplanke, ermitteln. Die zweite Messeinrichtung kann einen akustischen Sensor und/oder einen Ultraschallsensor aufweisen. Die Markierungen können ein Barcode sein. Die Markierungen können Striche aufweisen, deren längere Seite sich einen Teil der Breite der Fahrbahn in Fahrbahnquerrichtung erstreckt und deren kürzere Seite sich in Fahrbahnlängsrichtung erstreckt.

Wenn sich das Reinraumshuttle in einer zweiten Fahrtrichtung bewegt, die sich quer zur ersten Fahrtrichtung befindet kann das Reinraumshuttle dazu ausgebildet sein, die Position des Reinraumshuttles aufgrund von Umdrehungen eines Antriebsmotors zumindest eines Rades zu ermitteln. Der Begriff "quer" zur ersten Fahrtrichtung kann senkrecht zur ersten Fahrtrichtung aber auch jeden beliebigen Winkel zur ersten Fahrtrichtung umfassen. Der Begriff "quer" zur ersten Fahrtrichtung kann einen Winkelbereich von 15° bis 165°, vorzugsweise von 30° bis 150°, mehr bevorzugt von 45° bis 135°, höchstbevorzugt von 75° bis 105°, meist bevorzugt 85° bis 95°, umfassen. Die Umdrehungen des Motors können mittels eines Sensors, beispielsweise eines Inkrementalgebers, ermittelt werden. Der Motor kann ein beliebiger Antriebsmotor eines der Räder des Reinraumshuttles sein.
Das Reinraumshuttle kann dazu ausgebildet sein, wenn sich das Reinraumshuttle in der zweiten Fahrtrichtung bewegt, die Position des Reinraumshuttles in Richtung der zweiten Fahrtrichtung mittels der zweiten Messeinrichtung zu ermitteln und die Position des Reinraumshuttles senkrecht zur zweiten Fahrtrichtung mittels einer dritten Messeinrichtung gegenüber einem Fahrbahnende zu ermitteln. Die dritte Messeinrichtung kann eine Ultraschallmesseinrichtung und/oder eine Lasermesseinrichtung aufweisen. Das Fahrbahnende kann eine Leitplanke oder eine Öffnung in der Fahrbahn sein, durch die der Behälter herabgelassen oder aufgenommen werden kann.
Das Reinraumshuttle kann schwenkbare Greifmittel aufweisen, die unter komplementäre Greifmittlel des Behälters schwenkbar sind. Die Greifmittel können Schwerter sein. Da die Greifmittel schwenkbar sind, entfällt eine Längsführung, wodurch Reibung und Abrieb vermieden werden.

Denkbar ist auch ein Verfahren zum Positionieren eines Reinraumshuttles mit dem Schritt des Fahrens des Reinraumshuttles in einer ersten Richtung auf einer Fahrbahn, die über dem Hallenboden eines Reinraums angeordnet ist, wobei sich die Räder des Reinraumshuttles in einer ersten Position befinden. Die Position des Reinraumshuttle wird berührungslos ermittelt. Das berührungslose Ermitteln der Position des Reinraumshuttle umfasst, dass das Reinraumshuttle keine Referenzobjekte oder dergleichen berühren muss, um die Position im Raum zu ermitteln. Das Reinraumshuttle ermittelt den Referenzpunkt berührungslos. Das Reinraumshuttle kann anhalten und alle Räder, die die Fahrbahn berühren, können in eine zweite Stellung geschwenkt werden, die sich quer zur ersten Richtung befindet. Anschließend kann sich das Reinraumshuttle entlang der zweiten Richtung bewegen. Nach dem Anhalten kann das Reinraumshuttle den Behälter, beispielsweise durch eine Öffnung in der Fahrbahn mittels des zuvor beschriebenen Greifers herablassen oder aufnehmen.

Die Erfindung wurde zuvor im Zusammenhang mit einem Reinraumshuttlesystem beschrieben. Die Anmelderin behält sich vor, das Reinraumshuttle und/oder ausgewählte Aspekte des Reinraumshuttle separat zu beanspruchen.

Die Erfindung wird nachstehend unter Bezugnahme auf nicht beschränkende Ausführungsformen erläutert, die den Schutzbereich der Patentansprüche nicht beschränken.

In den Figuren zeigen:
Figur 1 einen Querschnitt durch das erfindungsgemäße Reinraumshuttlesystem ;
Figur 2 einen Querschnitt der Radaufhängung des erfindungsgemäßen Reimraumshuttle;
Figur 3 die Bodenplatte bzw. das Chassis des Reinraumshuttle;
Figur 4 eine Fahrbahn mit einer Kreuzung des erfindungsgemäßen Reimraumshuttlesystems;
Figur 5 eine perspektivische Darstellung einer Hebeeinrichtung des Reimraumshuttle;
Figur 6 eine perspektivische Ansicht eines Teils der Hebeeinrichtung;
Figur 7 eine perspektivische Ansicht eines Greifers von der Oberseite;
Figur 8 eine perspektivische Ansicht des Greifers von unten;
Figur 9 einen Querschnitt eines Greifers mit einem Behälter;
Figur 10 einen Querschnitt des Greifers;
Figur 11 eine bevorzugte Sensoranordnung; und
Figur 12 eine Seilwickel- und Andrückanordnung.

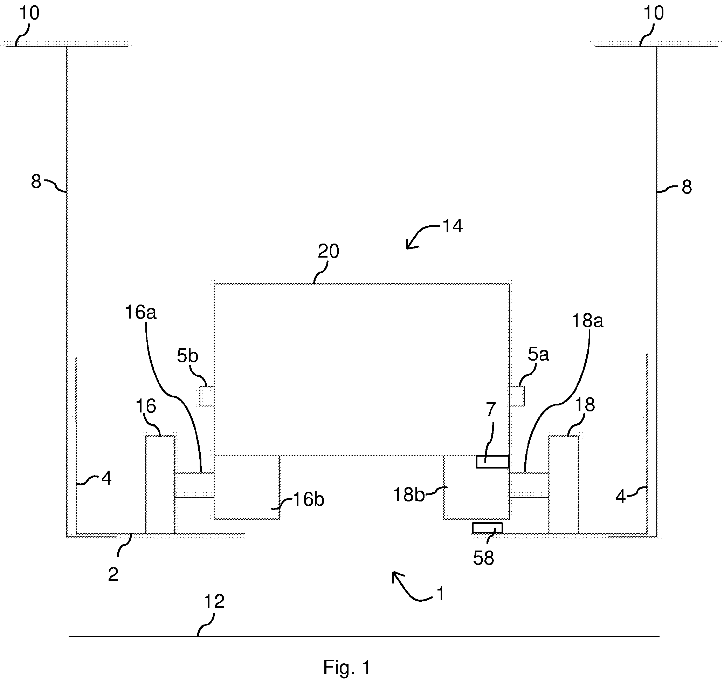

Figur 1 zeigt einen Querschnitt durch ein erfindungsgemäßes
Reimraumshuttlesystem 1. Das Reimraumshuttlesystem umfasst eine Fahrbahn 2, an der eine optionale Leitplanke 4 angeordnet ist. Die Fahrbahn ist mittels Träger 8 an einer Deckenkonstruktion 10 eines Reinraumes höher als die Bodenoberkante 12 des Reinraums angeordnet. Das erfindungsgemäße Reimraumshuttlesystem 1 umfasst ferner ein Reinraumshuttle, das auf einer Mehrzahl von Rädern 16, 18 auf der Fahrbahn 2 fährt, wobei die Räder die Fahrbahn berühren. Das Reinraumshuttle setzen umfasst Radaufhängungen 16b, 18b, an denen mittels einer Achse 16a, 18a das Rad 16, 18 angeordnet ist. Ferner umfasst das Reinraumshuttle 14 einen Körper 20, in dem ein Behälter (nicht gezeigt) transportiert werden kann.

Das Reinraumshuttle 14 umfasst eine erste Messeinrichtung 7, die dazu ausgebildet ist, Markierungen 58 auf einer Fahrbahn zu messen. Dadurch kann die Position des Reinraumshuttles, beispielsweise in Längsrichtung der Fahrbahn bestimmt werden. Ferner umfasst das Reinraumshuttle 14 eine zweite Messeinrichtung 5a, 5b, die dazu ausgebildet ist, die Position des Reinraumshuttles gegenüber einem Punkt zu messen. Der Punkt kann die Leitplanke 4 sein. Üblicherweise wird die zweite Messeinrichtung 5a, 5b dazu verwendet, die Position des Reinraumshuttles in Querrichtung zu ermitteln. Die erste Messeinrichtung 7 kann beispielsweise einen Barcodesensor umfassen. Die zweite Messeinrichtung 5a, 5b kann eine lasergestützte und/oder eine ultraschallgestützte Messeinrichtung sein.

Die zweite Messeinrichtung 5a, 5b kann eine optische Messeinrichtung sein, die eine Linie auf einer Fahrbahn auswertet, um die Position des Reinraumshuttles 14 in der Querrichtung zu ermitteln. Die optische Messeinrichtung kann ein Prisma aufweisen.

Ferner ist es möglich die Position des Reinraumshuttles mittels elektromagnetischer Wellen zu ermitteln, wie es beispielsweise bei einem GPS-System der Fall ist. Beispielsweise können Sender für elektromagnetische Wellen in dem Reinraum angeordnet werden. Je nach Winkel und/oder Laufzeit des eintreffenden Signales einer Quelle kann das Reinraumshuttle 14 seine Position im Raum ermitteln.

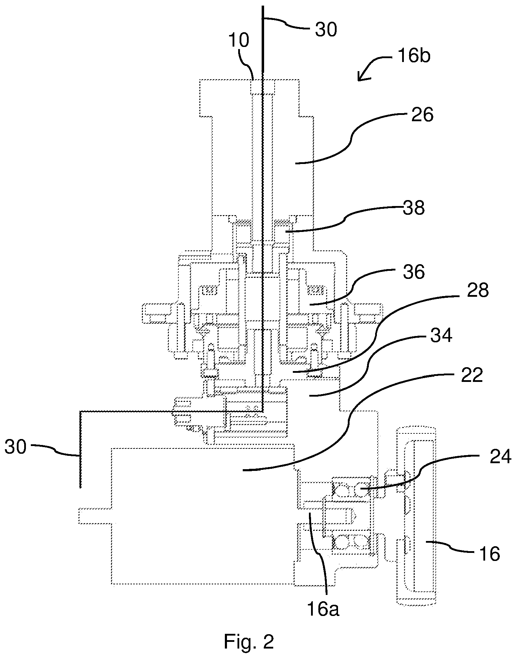

Es wird auf Figur 2 Bezug genommen, die einen Schnitt durch eine Radaufhängung 16b zeigt. Ein Schrittmotor 22 treibt über die Achse 16a, die von einem Kugellager 24 gelagert ist, das Rad 16 an. Das Kugellager 24 kann ein zweireihiges Schrägkugellager sein. Das Rad 16 ist vorzugsweise aus einem leitfähigen Polyurethanmaterial hergestellt. Der Schrittmotor 22 erzeugt den Vortrieb des Reinraumshuttle, und das Rad 16 wird vorzugsweise von dem Schrittmotor 22 ohne Getriebe direkt angetrieben. Der Schrittmotor 22 wird über ein Kabel 30 mit Strom versorgt. Ferner umfasst die Radaufhängung 16b einen Radträger 34 in dem auch das Kabel 30 geführt wird. Der Radträger 34 ist über ein optionales Getriebe 36 über eine Kupplung 38 mit einem Lenk-Schrittmotor 26 verbunden. Der Radträger 34 ist ferner fest mit einer Hohlwelle 28 verbunden, die durch den Lenk-Schrittmotor 26 verläuft und die das Getriebe 36 antreibt. Die Hohlwelle 28 bildet die Schwenkachse des Rades 16, das exzentrisch zur Schwenkachse gelagert ist. Im Inneren der Hohlwelle verläuft das Kabel zur Versorgung des Schrittmotors 22 mit Steuersignalen und/oder eine Energieversorgung. Durch diesen Aufbau kann eine Partikelemission in den Reinraum vermieden werden. Ferner ist es möglich, zusätzlich zum Schrägkugellager 24 eine Labyrinthdichtung oder eine Ferrofluiddichtung zu verwenden, um zu verhindern, dass Partikel in den Reinraum emittiert werden.

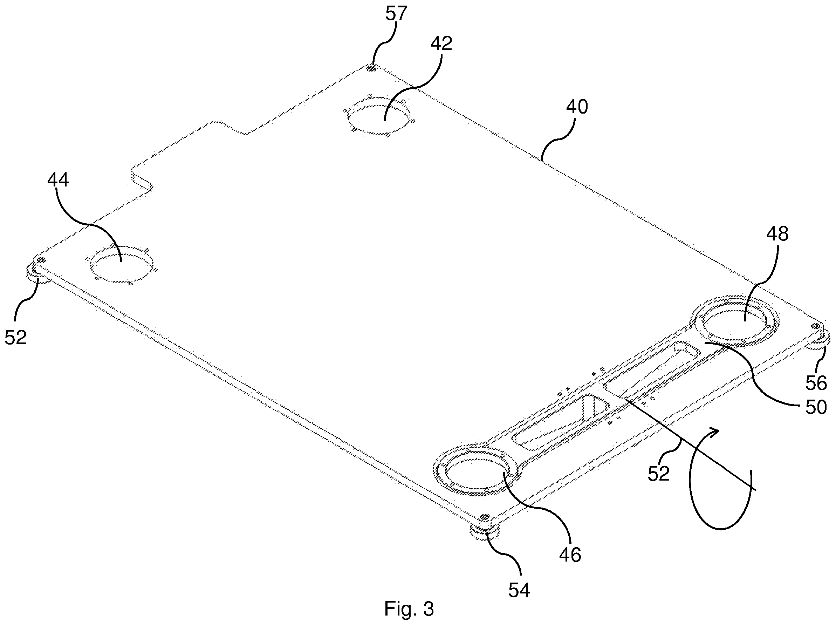

Es wird auf Figur 3 Bezug genommen, die eine Bodenplatte bzw. das Chassis 40 des Reinraumshuttle zeigt. Die Bodenplatte umfasst eine Mehrzahl von Befestigungen 42, 44, 46, 48 für eine Radaufhängung. Die Befestigungen 42, 44, 46, 48 sind bei dieser Ausführungsform als Öffnungen ausgebildet. Zwei Befestigungen 46, 48 für Radaufnahmen sind an einem Träger 50 angeordnet, der um eine Achse 52 schwenkbar am Chassis bzw. der Bodenplatte 40 angeordnet ist. Dadurch können Unebenheiten in der Fahrbahn ausgeglichen werden, so dass immer alle vier Räder die Fahrbahn berühren.

Es versteht sich, dass das Chassis 40 nicht notwendigerweise als Platte ausgebildet sein muss und dass die Befestigungen 42, 44, 46, 48 für die Radaufhängung nicht notwendigerweise als Öffnungen ausgebildet sein müssen.

Ferner umfasst das Chassis 40 drehbar gelagerte Schutzräder 52, 54, 56, 57, die eine Beschädigung des Reinraumshuttle und der Leitplanke 4 vermeiden, falls im Fall einer Fehlfunktion das Shuttle an einer Leitplanke 4 anstößt. Die Schutzräder sind aus Polyurethan hergestellt.

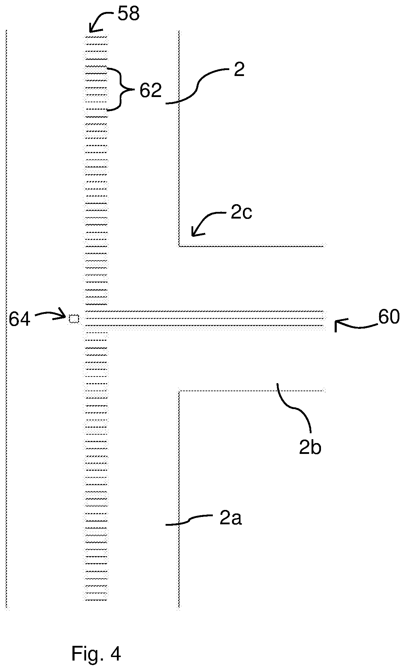

Es wird auf Figur 4 Bezug genommen, die eine Kreuzung zwischen zwei Fahrbahnen 2, 2a und 2b zeigt. Entlang der Fahrbahn ist ein Streifenmuster 58 angeordnet, so dass das Reinraumshuttle auf den Fahrbahnen 2, 2a mittels des Streifenmusters 58 fahren kann. Die Position des Reinraumshuttle in Fahrbahnlängsrichtung wird entlang der breiten Seite der Streifen bestimmt. Die Position des Reinraumshuttle in Fahrbahnquerrichtung wird entlang der schmalen Seite der Streifen bestimmt. Die Streifen sind im wesentlichen äquidistant angeordnet, wie mittels des Streifenmusters 62 gezeigt ist.

Ferner kann das Streifenmuster 58 eine Referenzmarkierung 64 aufweisen. Bei dem in Figur 4 gezeigten Beispiel befindet sich die Referenzposition 64 an einer Kreuzung zwischen den drei Fahrbahnen 2, 2a und 2b. Das Streifenmuster 60 ist parallel zum Streifenmuster 58 angeordnet. Das Reinraumshuttle kann beispielsweise über die Fahrbahn 2 entlang des Streifenmusters 58 zum Kreuzungspunkt 64 zwischen den Mustern 58 und 60 fahren. Am Kreuzungspunkt kann das Reinraumshuttle seine Geschwindigkeit mehr oder minder zu Null reduzieren und alle lenkbare Räder um 90° schwenken, so dass das Shuttle entlang dem Streifenmuster 60 fährt.

Dadurch ist es möglich, ein besonders Platz sparendes Reinraumshuttlesystem aufzubauen und nahezu jede beliebige Position in einer bestehenden Reinraumumgebung anzufahren.

Das Reinraumshuttle 14 befindet sich in seiner ersten Fahrtrichtung, wenn es entlang dem Streifenmuster 58 fährt. In diesem Fall bestimmt die erste Messeinrichtung 7 die Position des Reinraumshuttles 14 in der Fahrbahnlängsrichtung anhand des Streifenmusters 58. Bei der ersten Fahrtrichtung bestimmt die zweite Messeinrichtung 5a, 5b die Position des Reinraumshuttles 14 zum Fahrbahnrand.

Das Reinraumshuttle befindet sich in seiner zweiten Fahrtrichtung, wenn es entlang dem Streifenmuster 60 fährt. Die erste Messeinrichtung 7 bestimmt bei der zweiten Fahrtrichtung die Position des Reinraumshuttles gegenüber dem Fahrbahnrand auf Grundlage des Streifenmusters 60. Die Position des Reinraumshuttles 14 in Fahrbahnlängsrichtung bestimmt bei der zweiten Fahrtrichtung die zweite Messeinrichtung 5a, 5b.

Es versteht sich, dass beliebige Markierungen verwendet werden können, um dem Reinraumshuttle zu ermöglichen, seine Positionen im Weltkoordinatensystem zu verwenden. Ferner können beliebige Referenzmarkierungen vorgesehen werden, die ermöglichen, dass das Reinraumshuttle seine Position gegenüber dem Weltkoordinatensystem bestimmen bzw. korrigieren kann.

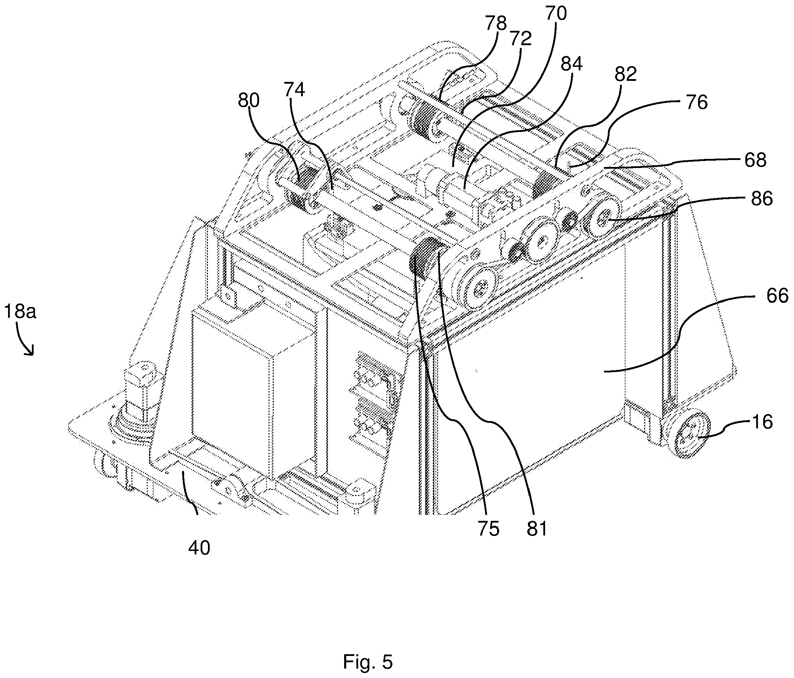

Figur 5 zeigt eine perspektivische Draufsicht auf ein erfindungsgemäßes Reinraumshuttle 14. Figur 5 zeigt ein Rad 16 und eine Radaufhängung 18, die an der Bodenplatte 40 angeordnet sind. An der Oberseite des Reinraumshuttle 14 befindet sich eine Hebeeinrichtung 68, die dazu ausgebildet ist, einen Behälter 66, in dem beispielsweise eine Mehrzahl von Wafer angeordnet sein kann, zu heben und zu senken. Der Behälter wird von einem Greifer gegriffen, der an einer Greiferplatte 70 angeordnet ist. Die Greiferplatte 70 wird mittels Seilen 72, 74, 75, 76 bewegt, die an Trommeln 78, 80, 81, 82 mit einer helixförmige Vertiefung aufgerollt bzw. abgerollt werden können. Die helixförmige Vertiefung vermeidet, dass durch Reibung von Seilbereichen aneinander Partikel entstehen, die in den Reinraum abgegeben werden. Die Trommeln 78, 80, 81, 82 werden von einem Elektromotor 84 über ein Getriebe 86 angetrieben.

Die Seile 72, 74, 75, 76 sind vorzugsweise Stahlseile, die mit Polyurethan ummantelt sind. Über die Seile 72, 74, 75, 76 können Daten und/oder Energie in Form elektrische Signale übertragen werden.

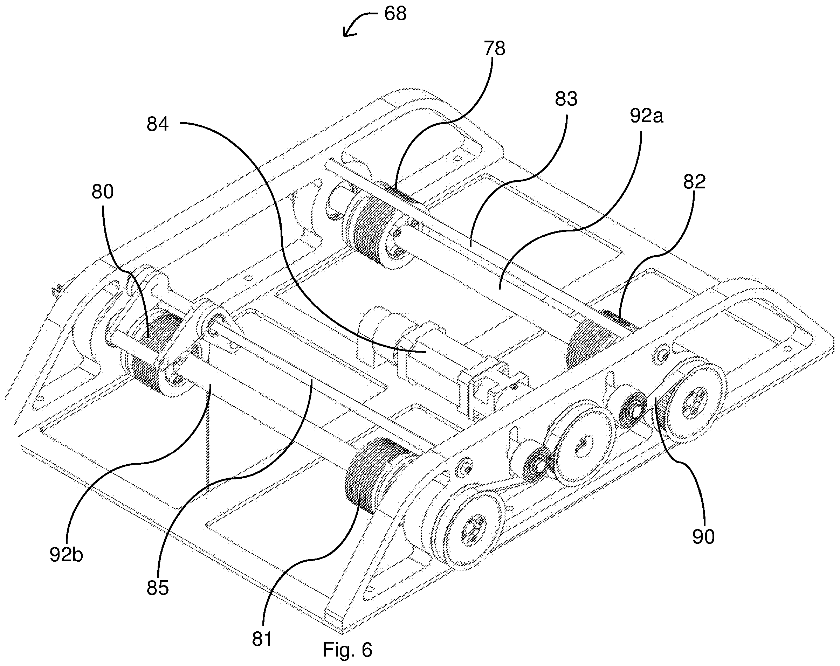

Es wird auf Figur 6 Bezug genommen, die einen Teil der Hebeeinrichtung 68 perspektivisch darstellt. Die Hebeeinrichtung umfasst einen Elektromotor 84, der über ein erstes Antriebsrad einen Riemen 90 antreibt, der über ein zweites Antriebsrad eine erste Welle 92a und über ein drittes Antriebsrad eine zweite Welle 92b antreibt. An der ersten Welle sind die Trommeln 78 und 84 angeordnet. An der zweiten Welle sind die Trommeln 80 und 81 angeordnet. Jede der Trommeln umfasst eine helixförmige Vertiefung, in der ein Seil aufgenommen werden kann, das mit dem Greifer gekoppelt ist.

Die Seile 72, 74, 75, 76 werden von der jeweiligen Trommel 78, 80, 81, 82 aufgerollt. Ferner werden die Seile durch die Trommel in die Welle 83, 85 geführt. Die Wellen 83, 85 sind Hohlwellen und die Seile werden in den Hohlwellen geführt. Die Seile werden durch eine sogenannte Dreheinführung (nicht gezeigt) aus den Hohlwellen herausgeführt und an einer Stromversorgung bzw. einer Kommunikationseinrichtung angeschlossen.

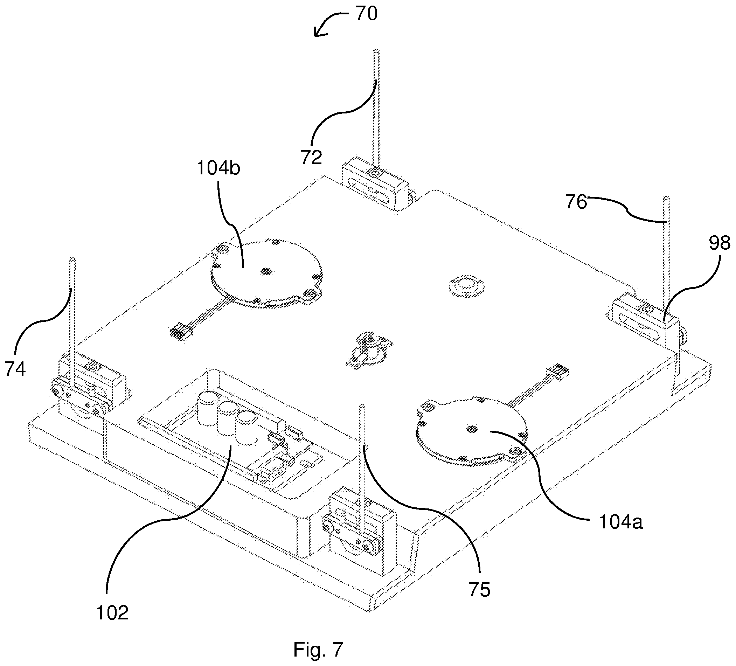

Figur 7 zeigt eine perspektivische Ansicht des Greifers. Der Greifer ist mit der Hebeeinrichtung durch die Seile 72, 74, 75, 76 gekoppelt, die mittels Klemmeinrichtungen 98 mit dem Greifer 70 gekoppelt sind. Über jedes der Seile 72, 74, 75, 76 können Steuersignale und/oder Energie elektrisch übertragen werden. Der Greifer umfasst eine elektronische Steuerungseinrichtungen 102, die zumindest ein Aktor, beispielsweise einen Schrittmotor, 104a, 104b ansteuert. Der zumindest eine Aktor 104a, 104b kann den Behälter greifen bzw. klemmen.

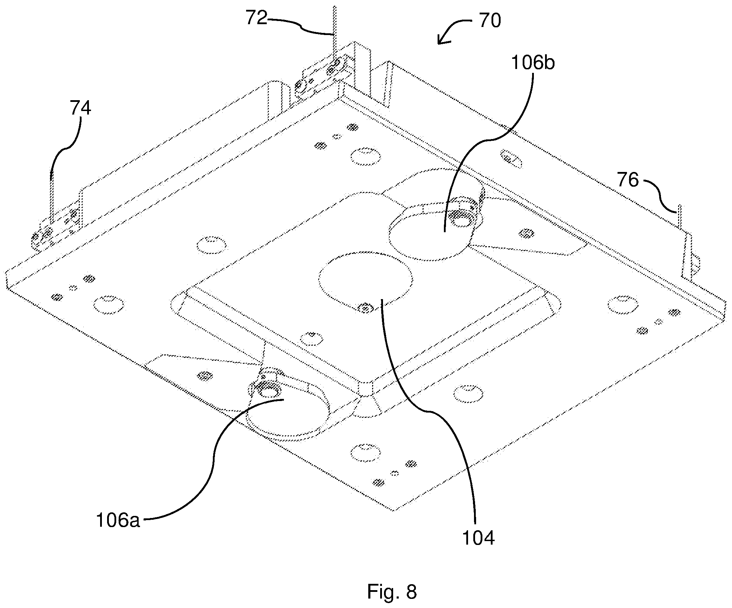

Figur 8 zeigt die Unterseite eines Greifers des erfindungsgemäßen Reinraumshuttle. Der Greifer wird, wie zuvor erwähnt wurde, mittels der Seile 72, 74, 76 durch die Hebeeinrichtung gehalten. Die Unterseite des Greifers umfasst einen Zentrierkegel 104, der den Greifer 70 auf dem Behälter zentriert. Mit den in Figur 7 gezeigten Aktoren 104a, 104b ist jeweils ein Nocken bzw. ein Schwert 106a, 106b gekoppelt, die in entsprechende Schlitze des Behälters (nicht gezeigt) eingreifen, um diesen zu greifen. Sobald die Schwerter 106a, 106b in den Behälter eingreifen, kann dieser durch die Hebeeinrichtung mittels der Seile 72, 74, 75, 76 gehoben oder gesenkt werden.

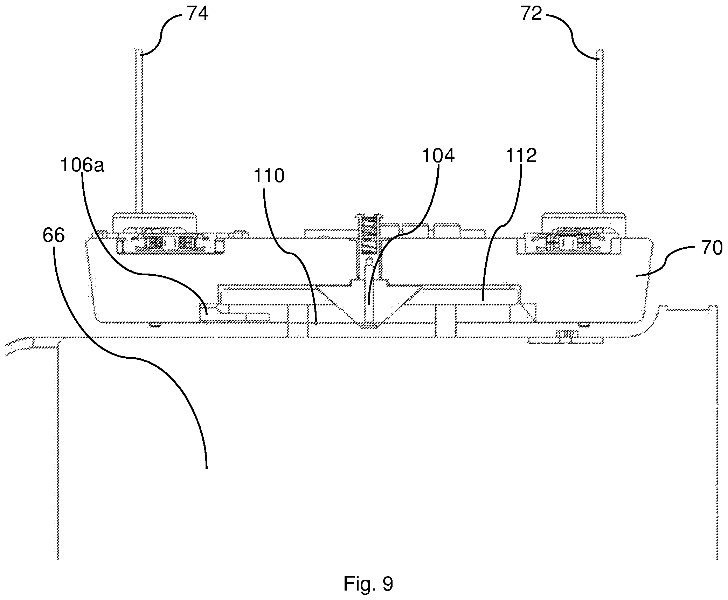

Figur 9 zeigt einen Schnitt durch den Behälter 66 und den Greifers 70. Der Greifer 70 wird an den Seilen 72, 74 und weiteren in Figur 9 nicht gezeigten Seilen gehalten und umfasst den an einer Feder elastisch gelagerten Zentrierkegel 104. Der Zentrierkegel zentriert den Greifer gegenüber dem Behälter 66, indem der Zentrierkegel 104 in eine dazu komplementäre Aufnahme 110 eingreift. Ferner umfasst der Greifer zumindest zwei drehbar gelagerte Schwerter 106a, die unter einem Flansch 112 des Behälters 66 eingreifen.

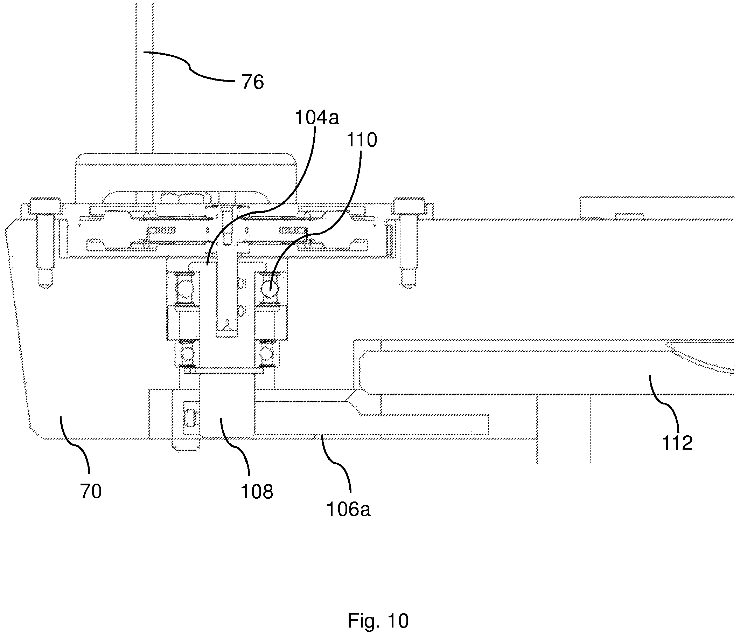

Figur 10 zeigt einen weiteren Schnitt durch den Greifer 70. Der Greifer wird von dem Seil 76 und weiteren nicht gezeigten Seilen gehalten. Im Greifer ist ein Schrittmotor 104a angeordnet, der eine Welle 108 antreibt, die von einem Rillenkugellager 110 gelagert wird. Die Welle 108 treibt das Verriegelungsschwert 106a an, so dass das Verriegelungsschwert 106a unter die Flansche 112 des Behälters 66 geschwenkt werden kann, um den Behälter zu heben.

Die Greifer führen eine Schwenkbewegung aus, um unter den Flansch 112 des Behälters 66 einzugreifen. Daher benötigen die Schwerter 106a, 106b keine Seitenführung, wodurch die Reibung und die Partikelemission reduziert werden.

Die Schwerter 106a, 106b können sich in einer Verriegelungsstellung befinden, sobald sie unter einem Flansch 112 des Behälters geschwenkt sind. Es kann ein Sensor vorgesehen sein, mittels dessen abgefragt wird, ob sich die Schwerter 106a, 106b in ihrer Verriegelungsstellung unter den Flansch 112 des Behälters befinden. Falls sich die Verriegelungsschwerter 106a, 106b in ihrer Verriegelungsstellung befinden, kann der Greifer den Behälter 66 mittels der Seile anheben.

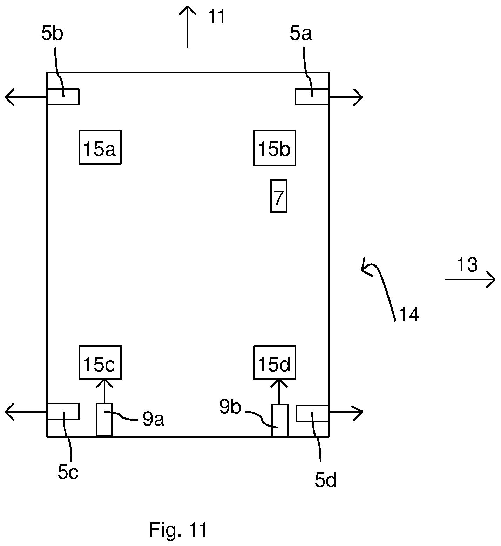

Es wird auf Figur 11 Bezug genommen, die beispielhaft Sensoren des Reinraumshuttles 14 zeigt. Die erste Messeinrichtung 7 ermittelt die Position des Reinraumshuttles 14 gegenüber Markierungen auf der Fahrbahn 58 (siehe Figur 1), wenn sich das Reinraumshuttle 14 in die erste Richtung 11 bewegt. Die erste Messeinrichtung kann eine optische Messeinrichtung sein. Die zweiten Messeinrichtungen 5a, 5b, 5c, 5d ermitteln die Position des Reinraumshuttles 14 gegenüber einem Punkt, beispielsweise einer Fahrbahnbegrenzung, senkrecht zur ersten Fahrtrichtung 11, wenn sich das Reinraumshuttle 14 in der ersten Fahrtrichtung bewegt. Die zweiten Messeinrichtungen 5a, 5b, 5c, 5d geben ein Messsignal senkrecht zur ersten Fahrtrichtung aus und können den Abstand des Reinraumshuttles 14 zu einem Punkt entlang einer Richtung senkrecht zur ersten Fahrtrichtung 11 ermitteln.

Wenn sich das Reinraumshuttle 14 in die zweite Richtung 13 bewegt, wird die Strecke, die das Reinraumshuttle 14 in der zweiten Richtung 13 zurückgelegt hat, mittels Drehsensoren 15a, 15b, 15c, 15d ermittelt, die ermitteln, wieweit sich ein Radantriebsmotor bzw. ein Rad gedreht hat. Die dritten Messeinrichtungen 9a und 9b messen den Abstand des Reinraumshuttles 14 quer zur zweiten Fahrtrichtung 13, beispielsweise gegenüber einer Fahrbahnbegrenzung. Die dritte Messeinrichtung kann eine Ultraschallmesseinrichtung und/oder eine Lasermesseinrichtung sein. Ferner können die zweiten Messeinrichtungen 5a, 5d sowie 5b und 5c dazu verwendet werden, um den Abstand des Reinraumshuttles 14 zu einem Punkt zu ermitteln, beispielsweise einer Fahrbahnbegrenzung. Dies ist insbesondere bei einer Feinpositionierung des Reinraumshuttles 14 vor dem Abseilen des Behälters nützlich.

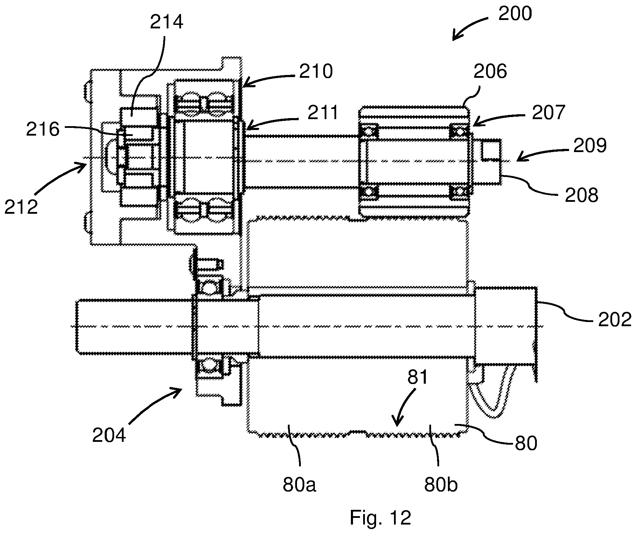

Es wird auf Figur 12 Bezug genommen, die eine Seilwickel- und Andrückrollenanordnung zeigt, bei der mehrere Seile synchron auf einer Achse gewickelt werden. Die Trommel 80 kann zumindest zwei Wickelbereiche 80a, 80b aufweisen, deren helixförmigen Vertiefungen gegenläufige Steigungen aufweisen können. Die Trommel 80, von der das Seil 74 zum Heben und Senken des Greifers 70 aufgewickelt bzw. abgewickelt wird, ist auf einer Trommelwelle 202 angeordnet, die an einem Trommellager 204 gelagert ist. Eine Andrückrolle 206, die das Seil an die Trommel 80 andrückt, ist mittels eines Lagers 207 auf einer Andrückwelle 208 um die Andrückachse 209 drehbar gelagert. Die Andrückwelle 208 ist an einem Exzenter 211 befestigt, der um eine Exzenterachse 212 schwenkbar ist.

Der Exzentermechanismus 211 wird von einem Exzenterlager 210 drehbar gelagert. An der Exzenterachse 212 ist ein innerer Ringmagnet 216 angebracht, der sich mit dem Exzentermechanismus 211 um die Exzenterachse 212 drehen kann. Um den inneren Magnetring 216 ist ein äußerer Magnetring 214 angeordnet.

Der innere Magnetring 216 und der äußere Magnetring 214 wirken mittels des Exzentermechanismus 211 so, dass sie die Andrückrolle 206 federnd gegen die Trommel 80 drücken. Dadurch wird sichergestellt, dass das Seil in die helixförmige Vertiefung 81 der Trommel gedrückt wird und andererseits keine so hohe Kraft ausgeübt wird, dass ein Abrieb am Seil, an der Trommel 80 und/oder an der Andrückrolle 206 verursacht wird. Dadurch kann die Partikelemission des Reinraumshuttles 14 weiter reduziert werden und gleichzeitig die Zuverlässigkeit des Reinraumshuttles 14 erhöht werden.

Die vorliegende Erfindung weist den Vorteil auf, dass das Reinraumshuttle weniger Abrieb erzeugt. Ferner kann das erfindungsgemäße Reinraumshuttle flexibel in beliebigen Produktionsumgebungen eingesetzt werden, da keine Mindestradien für eine Kurve erforderlich sind und das Reinraumshuttle so genannte Stichfahrten durchführen kann.

## Patentansprüche

1. Reinraumshuttlesystem (1), das dazu ausgebildet ist, in einem Reinraum Gegenstände (66) zu transportieren, und das dazu ausgebildet ist, die Anforderungen an die maximale Partikelemission des Reinraums zu erfüllen, mit
- einer Fahrbahn (2, 2a, 2b) , auf der sich ein Rad (16, 18) in zumindest zwei Dimensionen bewegen kann und die höher als die Raumbodenoberkante (12) des Reinraums angeordnet ist; und
- einem Reinraumshuttle (14), das zumindest drei lenkbare Räder (16, 18) aufweist, die sich auf der Fahrbahn (2, 2a, 2b) bewegen und diese berühren,
wobei sich der Punkt, auf dem das Rad (16, 18) die Fahrbahn berührt, exzentrisch zu der Achse (28) befindet, um die das Rad (16, 18) während einer Lenkbewegung geschwenkt wird, **dadurch gekennzeichnet, dass**
- jedes der Räder des Reinraumshuttle (14) einen Lenkantrieb aufweist, der das Rad (16, 18) für eine Lenkbewegung schwenkt,
- jedes der Räder des Reinraumshuttle (14) durch einen Vortriebsantrieb (22) angetrieben wird, der das Reinraumshuttle (14) bewegt und
- jedes Rad des Reinraumshuttles, das den Boden berührt, individuell und unabhängig voneinander lenkbar ist.

2. Reinraumshuttlesystem (1) nach Anspruch 1, **dadurch gekennzeichnet, dass** das Reinraumshuttle zumindest vier lenkbare Räder (16, 18) aufweist, die sich auf der Fahrbahn (2, 2a, 2b) bewegen und diese berühren.

3. Reinraumshuttlesystem (1) nach Anspruch 1 oder 2, **dadurch gekennzeichnet, dass** jedes der Räder (16, 18) des Reinraumshuttle (14) eine Lenkbewegung um zumindest 90° durchführen kann.

4. Reinraumshuttlesystem (1) nach einem der Ansprüche 1 bis 3, **dadurch gekennzeichnet, dass** die Lenkachse (28), um die das Rad (16) des Reinraumshuttle (14) während des Lenkens geschwenkt wird, hohl ausgebildet ist.

5. Reinraumshuttlesystem (1) nach einem der Ansprüche 1 bis 4, **dadurch gekennzeichnet, dass** das Reinraumshuttle (14) eine Steuerungseinrichtung aufweist, die dazu ausgebildet ist, jedes der zumindest drei Räder (16,18) um einen vorbestimmten Betrag zu schwenken, so dass das Reinraumshuttle (14) nach einer Fahrt in einer ersten Richtung (2) die Fahrt in eine zweite Richtung (2b) fortsetzt, wobei sich die erste Richtung unter einem Winkel zur zweiten Richtung befindet.

6. Reinraumshuttlesystem (1) nach einem der Ansprüche 1 bis 5, **dadurch gekennzeichnet, dass** zumindest zwei Räder des Reinraumshuttle an einem Träger (50) angeordnet sind, der gegenüber dem Chassis (40) des Reinraumshuttle schwenkbar angeordnet ist.

7. Reinraumshuttlesystem (1) nach einem der Ansprüche 1 bis 6, **dadurch gekennzeichnet, dass** das Reinraumshuttle (14) eine Hebeeinrichtung (68) aufweist, die dazu ausgebildet ist, dass sie einen Behälter (66) heben und/oder senken kann, wobei die Hebeeinrichtung (68) zumindest zwei Seile (72, 74, 76) aufweist, die einen Greifer (70) tragen, der den Behälter (66) greift, wobei über zumindest ein Seil (72, 74, 76) ein Kommunikationssignal und/oder eine Energieversorgung für den Greifer (70) übertragen werden.

8. Reinraumshuttlesystem (1) nach Anspruch 7, **dadurch gekennzeichnet, dass** die Hebeeinrichtung (68) eine helixfömige Vertiefung (81) aufweist, von der ein Seil beim Bewegen des Behälters aufgenommen wird.

9. Reinraumshuttlesystem (1) nach einem der Ansprüche 1 bis 8, **dadurch gekennzeichnet, dass** an der Fahrbahn (2, 2a, 2b) eine Leitplanke angeordnet ist, die verhindert, dass das Reinraumshuttle (14) von der Fahrbahn (2, 2a, 2b) abkommt.

10. Reinraumshuttlesystem (1) nach einem der Ansprüche 1 bis 9, **dadurch gekennzeichnet, dass** an der Fahrbahn (2, 2a, 2b) eine Mehrzahl von Markierungen (58, 60) angeordnet sind, und dass das Reinraumshuttle (14) zumindest einen Positionssensor aufweist, der dazu ausgebildet ist,
- die Position des Reinraumshuttle (14) in Fahrbahnlängsrichtung und/oder
- die Position des Reinraumshuttle (14) in Fahrbahnquerrichtung zu ermitteln.

11. Reinraumshuttlesystem (1) nach Anspruch 10, **dadurch gekennzeichnet, dass** das Reinraumshuttle (14) eine erste Messeinrichtung (7), die Markierungen auf der Fahrbahn auswertet, und eine zweite Messeinrichtung (5) aufweist, die den Abstand des Reinraumshuttles (14) zu einem Punkt (4) ermittelt, wenn sich das Reinraumshuttle (14) in einer ersten Richtung bewegt, wobei die Steuerungseinrichtung dazu ausgebildet ist, dass, wenn sich das Reinraumshuttle (14) in die erste Fahrtrichtung bewegt, die Position des Reinraumshuttles (14) entlang der Fahrbahn durch die erste Messeinrichtung (7) ermittelt wird und die Position senkrecht zur Fahrtrichtung durch die zweite Messeinrichtung (5) ermittelt wird.

12. Reinraumshuttlesystem (1) nach einem der vorangegangenen Ansprüche, **dadurch gekennzeichnet, dass** das Reinraumshuttle (14) dazu ausgebildet ist, wenn sich das Reinraumshuttle (14) in einer zweiten Fahrtrichtung bewegt, die sich quer zur ersten Fahrtrichtung befindet, die Position des Reinraumshuttles (14) aufgrund von Umdrehungen eines Antriebmotors zumindest eines Rades (16, 18) zu ermitteln.

13. Reinraumshuttlesystem (1) nach Anspruch 12, **dadurch gekennzeichnet, dass** das Reinraumshuttle (14) dazu ausgebildet ist, wenn sich das Reinraumshuttle (14) in der zweiten Fahrtrichtung bewegt, die Position des Reinraumshuttles (14) in Richtung der zweiten Fahrtrichtung mittels der zweiten Messeinrichtung zu ermitteln und die Position des Reinraumshuttles (14) senkrecht zur zweiten Fahrtrichtung mittels einer dritten Messeinrichtung gegenüber dem Fahrbahnende zu ermitteln.

14. Reinraumshuttlesystem (1) nach einem der vorangegangenen Ansprüche, **dadurch gekennzeichnet, dass** das Reinraumshuttle (14) schwenkbare Greifmittel (106a, 106b) aufweist, die unter komplementäre Greifmittel (112) des Behälters (66) schwenkbar sind.

## Claims

1. A clean room shuttle system (1) adapted to transport objects (66) in a clean room, and adapted to meet the requirements for the maximum particle emission of the clean room, comprising
- a carriageway (2, 2a, 2b) on which a wheel (16, 18) can move in at least two dimensions and which is arranged higher than the upper edge of the room bottom (12) of the clean room; and
- a clean room shuttle (14) which has at least three steerable wheels (16, 18) which move on the carriageway (2, 2a, 2b) and touch them,
wherein the point, on which the wheel touches the carriageway is located eccentrically with respect to the axis about which the wheel (16, 18) is pivoted during a steering movement, **characterized in that**
- each of the wheels of the clean-room shuttle has a steering drive which pivots the wheel (16, 18) for a steering movement,
- each of the wheels of the clean-room shuttle (14) is driven by a propulsion drive (22), which moves the clean-room shuttle (14) and
- each wheel of the clean room shuttle, which touches the ground, can be steered individually and independently of one another.

2. The clean room shuttle system (1) according to Claim 1, **characterized in that** the clean room shuttle comprises at least four steerable wheels (16, 18) which move on the carriageway (2, 2a, 2b) and touch them.

3. The clean room shuttle system (1) according to claim 1 or 2, **characterized in that** each of the wheels (16, 18) of the clean room shuttle (14) can carry out a steering movement by at least 90°.

4. The clean room shuttle system (1) according to one of claims 1 to 3, **characterized in that** the steering axis (28) about which the wheel (16) of the clean room shuttle (14) is pivoted during steering is hollow.

5. The clean room shuttle system (1) according to one of claims 1 to 4, **characterized in that** the clean room shuttle has a control device, which is adapted to pivot each of the at least three wheels (16, 18) by a predetermined amount such that the clean room shuttle (14) continues to travel in a second direction (2b) after a journey in a first direction (2), wherein the first direction is at an angle to the second direction.

6. The clean room shuttle system (1) according to one of claims 1 to 5, **characterized in that** at least two wheels of the clean-room shuttle are arranged on a carrier which is arranged such that it can pivot with respect to the chassis (40) of the clean room shuttle.

7. The clean room shuttle system (1) according to one of claims 1 to 6, **characterized in that** the clean room shuttle comprises a lifting device which is designed to raise and/or lower a container (66), wherein the lifting device (68) has at least two cables (72, 74, 76) which carry a gripper which engages the container (66), wherein a communication signal and/or an energy supply for the gripper (70) are transmitted via at least one cable (72, 74, 76).

8. The clean room shuttle system (1) according to claims 7, **characterized in that** the lifting device (68) comprises a helical recess (81), from which a cable is received when the container is moved.

9. The clean room shuttle system (1) according to one of claims 1 to 8, **characterized in that** a guide rail is arranged on the carriageway (2, 2a, 2b), which prevents the clean-space shuttle (14) from deviating from the carriageway (2,come away 2a, 2b).

10. The clean room shuttle system (1) according to one of claims 1 to 9, **characterized in that** a plurality of markings (58, 60) are arranged on the carriageway (2, 2a, 2b), and **in that** the clean room shuttle (14) has at least one position sensor which is adapted to detect,
- the position of the clean room shuttle (14) in the longitudinal direction of the carriageway and/or
- the position of the clean room shuttle (14) in the transverse direction of the carriageway is determined.

11. The clean room shuttle system (1) according to claim 10, **characterized in that** the clean room shuttle (14) comprises a first measuring device (7) which evaluates markings on the carriageway, and a second measuring device (5) which determines the distance of the clean room shuttle (14) to a point (4) when the clean room shuttle (14) moves in a first direction, wherein the control device is adapted such that, when the clean room shuttle (14) moves in the first direction of travel, the position of the clean room shuttle (14) along the carriageway is determined by the first measuring device (7) and the position perpendicular to the direction of travel is determined by the second measuring device (5).

12. The clean room shuttle system (1) according to one of the preceding claims, **characterized in that** the clean room shuttle (14) is adapted to determine the position of the clean room shuttle (14) on the basis of rotations of a propulsion drive of at least one wheel (16, 18), when the clean room shuttle (14) moves in a second direction of travel which is transverse to the first direction of travel.

13. The clean room shuttle system (1) according to claim 12, **characterized in that** the clean room shuttle (14) is adapted to determine the position of the clean room shuttle (14) in the direction of the second direction of travel by means of the second measuring device and to determine the position of the clean room shuttle (14) perpendicular to the second direction of travel by means of a third measuring device with respect to the end of the carriageway, when the clean room shuttle moves into the second direction of travel.

14. The clean room shuttle system (1) according to one of the preceding claims, **characterized in that** the clean room shuttle (14) has pivotable gripping means (106a, 106b) which can be pivoted under complementary gripping means (112) of the container (66).

## Revendications

1. Système de navette pour salle blanche (1) adapté pour transporter des objets (66) dans une salle blanche, et adapté pour satisfaire les exigences en termes d'émission maximum de particules de la salle blanche, comprenant :
- une voie de circulation (2, 2a, 2b) sur laquelle une roue (16, 18) peut se déplacer dans au moins deux dimensions et qui est agencée plus haut que le bord supérieur du fond de salle (12) de la salle blanche ; et
- une navette pour salle blanche (14) qui comporte au moins trois roues dirigeables (16, 18) qui se déplacent sur la voie de circulation (2, 2a, 2b) et qui sont en contact avec ;
dans lequel le point au niveau duquel la roue est en contact avec la voie de circulation est localisé de façon excentrée par rapport à l'axe autour duquel la roue (16, 18) est pivotée pendant un déplacement directionnel, **caractérisé en ce que** :
- chacune des roues de la navette pour salle blanche comporte un moyen d'entraînement directionnel qui fait pivoter la roue (16, 18) pour un déplacement directionnel ;
- chacune des roues de la navette pour salle blanche (14) est entraînée par un moyen d'entraînement par propulsion (22), lequel déplace la navette pour salle blanche (14) ; et
- chaque roue de la navette pour salle blanche, qui est en contact avec le sol, peut être dirigée de manière individuelle et de façon indépendante des autres.

2. Système de navette pour salle blanche (1) selon la revendication 1, **caractérisé en ce que** la navette pour salle blanche comprend au moins quatre roues dirigeables (16, 18) qui se déplacent sur la voie de circulation (2, 2a, 2b) et qui sont en contact avec.

3. Système de navette pour salle blanche (1) selon la revendication 1 ou 2, **caractérisé en ce que** chacune des roues (16, 18) de la navette pour salle blanche (14) peut mettre en oeuvre un déplacement directionnel sur au moins 90°.

4. Système de navette pour salle blanche (1) selon l'une quelconque des revendications 1 à 3, **caractérisé en ce que** l'axe directionnel (28) autour duquel la roue (16) de la navette pour salle blanche (14) est pivotée pendant le déplacement directionnel est creux.

5. Système de navette pour salle blanche (1) selon l'une quelconque des revendications 1 à 4, **caractérisé en ce que** la navette pour salle blanche comporte un dispositif de commande, lequel est adapté pour faire pivoter chacune des au moins trois roues (16, 18) d'une valeur de pivotement prédéterminée de telle sorte que la navette pour salle blanche (14) continue à cheminer dans une seconde direction (2b) après un trajet dans une première direction (2), dans lequel la première direction est selon un angle par rapport à la seconde direction.

6. Système de navette pour salle blanche (1) selon l'une quelconque des revendications 1 à 5, **caractérisé en ce qu'**au moins deux roues de la navette pour salle blanche sont agencées sur un support qui est agencé de telle sorte qu'il puisse pivoter par rapport au châssis (40) de la navette pour salle blanche.

7. Système de navette pour salle blanche (1) selon l'une quelconque des revendications 1 à 6, **caractérisé en ce que** la navette pour salle blanche comprend un dispositif d'élévation qui est conçu pour relever et/ou pour abaisser un moyen de contenance (66), dans lequel le dispositif d'élévation (68) comporte au moins deux câbles (72, 74, 76) qui supportent un moyen de préhension qui engage le moyen de contenance (66), dans lequel un signal de communication et/ou une alimentation en énergie pour le moyen de préhension (70) sont/est transmis via au moins un câble (72, 74, 76).

8. Système de navette pour salle blanche (1) selon la revendication 7, **caractérisé en ce que** le dispositif d'élévation (68) comprend un évidement en hélice (81) au niveau duquel un câble est reçu lorsque le moyen de contenance est déplacé.

9. Système de navette pour salle blanche (1) selon l'une quelconque des revendications 1 à 8, **caractérisé en ce qu'**un rail de guidage est agencé sur la voie de circulation (2, 2a, 2b), lequel empêche que la navette pour salle blanche (14) ne soit déviée par rapport à la voie de circulation (2, 2a, 2b).

10. Système de navette pour salle blanche (1) selon l'une quelconque des revendications 1 à 9, **caractérisé en ce qu'**une pluralité de repères (58, 60) sont agencés sur la voie de circulation (2, 2a, 2b), et **en ce que** la navette pour salle blanche (14) comporte au moins un capteur de position qui est adapté pour détecter
- la position de la navette pour salle blanche (14) dans la direction longitudinale de la voie de circulation ; et/ou
- la position de la navette pour salle blanche (14) dans la direction transversale de la voie de circulation est déterminée.

11. Système de navette pour salle blanche (1) selon la revendication 10, **caractérisé en ce que** la navette pour salle blanche (14) comprend un premier dispositif de mesure (7) qui évalue des repères sur la voie de circulation et un deuxième dispositif de mesure (5) qui détermine la distance de la navette pour salle blanche (14) par rapport à un point (4) lorsque la navette pour salle blanche (14) se déplace dans une première direction, dans lequel le dispositif de commande est adapté de telle sorte que, lorsque la navette pour salle blanche (14) se déplace dans la première direction de cheminement, la position de la navette pour salle blanche (14) le long de la voie de circulation soit déterminée au moyen du premier dispositif de mesure (7) et la position qui est perpendiculaire à la direction de cheminement soit déterminée au moyen du deuxième dispositif de mesure (5).

12. Système de navette pour salle blanche (1) selon l'une quelconque des revendications précédentes, **caractérisé en ce que** la navette pour salle blanche (14) est adaptée pour déterminer la position de la navette pour salle blanche (14) sur la base de rotations d'un moyen d'entraînement par propulsion d'au moins une roue (16, 18), lorsque la navette pour salle blanche (14) se déplace dans une seconde direction de cheminement qui est transversale par rapport à la première direction de cheminement.

13. Système de navette pour salle blanche (1) selon la revendication 12, **caractérisé en ce que** la navette pour salle blanche (14) est adaptée pour déterminer la position de la navette pour salle blanche (14) dans la direction de la seconde direction de cheminement au moyen du deuxième dispositif de mesure et pour déterminer la position de la navette pour salle blanche (14) perpendiculairement à la seconde direction de cheminement au moyen d'un troisième dispositif de mesure par rapport à l'extrémité de la voie de circulation, lorsque la navette pour salle blanche se déplace dans la seconde direction de cheminement.

14. Système de navette pour salle blanche (1) selon l'une quelconque des revendications précédentes, **caractérisé en ce que** la navette pour salle blanche (14) comporte un moyen de préhension pouvant pivoter (106a, 106b) qui peut être pivoté sous l'effet d'un moyen de préhension complémentaire (112) du moyen de contenance (66).
